Europäisches Patentamt

European Patent Office

Office européen des brevets

(11) Publication number: **0 054 412**
**B1**

(12) EUROPEAN PATENT SPECIFICATION

(45) Date of publication of patent specification: **23.04.86**

(51) Int. Cl.⁴: $H\ 01\ L\ 21/312$, $G\ 03\ F\ 7/26$

(21) Application number: **81305824.5**

(22) Date of filing: **10.12.81**

(54) Method of and apparatus for processing negative photoresist.

(30) Priority: **12.12.80 JP 175634/80**

(43) Date of publication of application:
**23.06.82 Bulletin 82/25**

(45) Publication of the grant of the patent:
**23.04.86 Bulletin 86/17**

(84) Designated Contracting States:
**DE FR GB NL**

(56) References cited:
**DE-A-2 945 630**
**US-A-4 298 803**

**NHK LABORATORIES NOTE; no. 253, August
1980 Tokyo pages 3-14**

(73) Proprietor: **FUJITSU LIMITED**
**1015, Kamikodanaka Nakahara-ku
Kawasaki-shi Kanagawa 211 (JP)**

(72) Inventor: **Kobayashi, Koichi
1502-70, Kitahassaku-cho Midori-ku
Yokohama-shi Kanagawa 226 (JP)**
Inventor: **Kawashima, Kenichi
24-26-102, Asahi-cho
Sagamihara-shi Kanagawa 228 (JP)**
Inventor: **Oshio, Shuzo
1538, Shukugawara Tama-ku
Kawasaki-shi Kanagawa 214 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

This invention relates to a method of and apparatus for processing negative photoresist.

As is generally known, the formation of fine patterns, of the order of submicron size, on semiconductor substrates is increasingly necessary in order to keep pace with the trend towards higher integration densities and maximum function densities for semiconductor devices such as integrated circuits (IC). For the preparation of such fine patterns by the so-called mask process method employing a photolithography technique, the known method involving exposure to ultraviolet light has been found ineffective for forming sufficiently fine patterns. Thus, various methods involving exposure to electron beams, X-ray beams, ion beams or deep ultra violet light are being developed and some are actually being used in practice. However, many of these new methods require a considerable processing time. For example, in the field of electron beam exposure, in an electron beam direct pattern writing method wherein electron beams directly impact photoresist film formed on a semiconductor substrate or wafer without the employment of any mask, the exposure step involves a period of a duration in the range from 50 or 60 minutes to several hours, although very precise and fine patterns can be formed.

In the method mentioned immediately above, exposure of negative photoresist to electron beams is carried out in a vacuum. When a wafer coated with such photoresist is removed from the vacuum to the outside atmosphere immediately after termination of exposure to electron beams, it has been found that the size of a pattern formed as a consequence of exposure to electron beams at an early stage of the exposure operation and the size of a pattern formed as a consequence of exposure of electron beams immediately before termination of the exposure operation differ when the patterns are developed.

The difference in pattern size corresponding to the length of curing time that has elapsed before developing arises as a result of differences in the bridging effect.

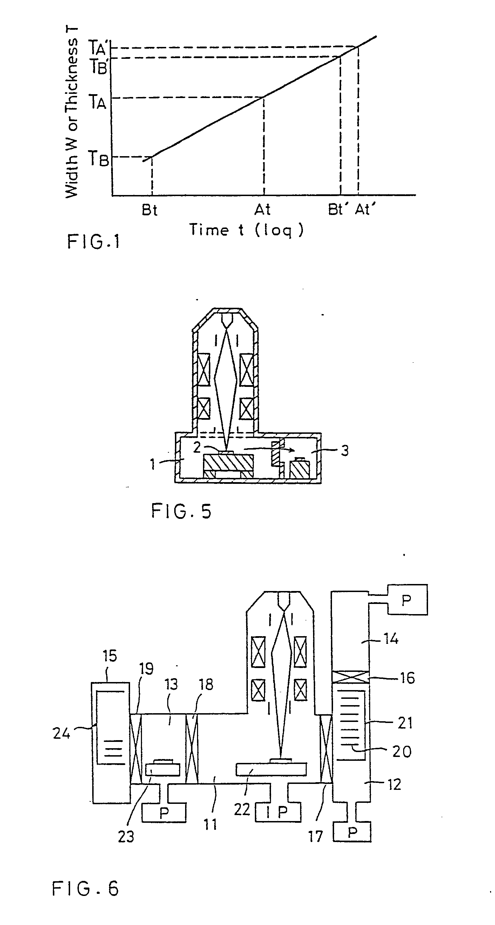

Figure 1 of the accompanying drawings is a graph illustrating the relationship between the width W or thickness T of a written pattern (indicated along the vertical axis in Figure 1) and the length of curing time t after exposure (indicated along the horizontal axis in Figure 1, on a logarithmic scale).

If a wafer is kept in vacuum in an electron beam exposure apparatus from a time At when pattern writing is commenced to a time Bt when pattern writing is finished, the width W or thickness T of lines written first and last respectively take the values $T_A$ and $T_B$ shown on the vertical axis in Figure 1, when the wafer is taken out of the vacuum relatively soon after exposure is completed. There is thus a difference ($T_A$—$T_B$), which is a substantial amount, between the widths or thicknesses of lines written soon after the beginning of exposure and near the end of exposure, respectively. The phenomenon just described is called the curing effect herein.

If the wafer is left for a considerable length of time, 1 hour for example, in the vacuum of the exposure apparatus, after exposure of the wafer to electron beams, the time consumed in pattern writing becomes small relative to the overall time spent in the apparatus. However, as will be seen from the graph of Figure 1, bearing in mind that the horizontal axis represents time on a logarithmic scale, the change ($T_A'$—$T_B'$) of pattern widths or thicknesses over the time (At'—Bt') is small, as shown in Figure 1. This means that, when the wafer is kept in the vacuum of the exposure apparatus for a considerable length of time, there is practically very little difference, ultimately, in the widths and thicknesses of lines formed in the first and last stages of exposure.

In view of the facts as described so far, measures have been taken to ensure that a wafer is left in vacuum for a certain length of time after exposure is completed. These measures have been unavoidably necessary because a slight difference in pattern size can amount to a significant defect in the formation of submicron patterns. However, the taking of such measures drastically reduces the rate of operation of the electron beam exposure apparatus.

In order to eliminate the above-described weakness experienced with conventional apparatus, an attempt was made to utilise effectively exposure time by providing the apparatus wherein a part of the conventional apparatus is kept in vacuum into which part substrates or wafers are successively transferred. However, even with such a structure, handling of wafers in vacuum is extremely difficult, involving deterioration of the degree of vacuum. Because of this there is a disadvantage in that control of the apparatus must be maintained very strictly.

The facts explained so far are separately disclosed in various Japanese Patent publications.

Japanese Patent Publication (Unexamined) No. 124397 of 1978, published on 30th October 1978, discloses an invention entitled "Transport Device". The apparatus according to that disclosed invention involves a technique for transferring articles irradiated by electron beams, ion beams, etc, in vacuum. In a paragraph bridging pages 1 and 2 of the specification of this publication, there appears a description which indicates that developments are being made to use electron beams and ion beams widely for treatment and processing of metals and other materials, for example dissolution, blowout, welding, heat treatment, sputtering, etching, ion implantation and the like.

Japanese Patent Publication (unexamined) No. 95189 of 1979, published on 27th July 1979, concerns an invention entitled "Electron Beam Exposure Device". On page 5 of the specification therein there is a description of a sub-chamber that is kept airtight for pumping out air. Articles to be treated are transported from the sub-chamber, in which there is thus maintained a vacuum, to an exposure chamber which is also kept in vacuum. On page 7 of the specification, there is a further explanation that the device is so arranged that once air is exhausted, an exposure process may be continuously effected in vacuum.

Japanese Patent Publication (unexamined) No. 68622 of 1980, published on 23rd May 1980, discloses an invention entitled "Device for Exchanging Samples in an Apparatus for Electron Beam Pattern Writing". On page 4 of the specification thereof is a description of a curing chamber which is kept in a vacuum of the order of less than $10^{-4}$ Torr. The curing chamber is independent of a chamber wherein samples are loaded and unloaded, and the object is to carry out curing of samples in vacuum in accordance with the claim of the specification. On page 6 of the specification, there appears a description which indicates that when pattern writing is over, samples are cured in vacuum without ejection of the mask to the outside atmosphere. Further, on page 7 of the specification, it is indicated that, for the purpose of improving exposure and stabilising the width of the lines of the pattern, curing in vacuum is necessary.

Japanese Patent Publication (unexamined) No. 146932 of 1980, published on 15th November 1980, discloses an invention entitled "Device for Exchange of Samples in an Apparatus for Electron Beam Pattern Writing". On page 3 of the specification thereof is a description stating that in a photoresist which has been exposed to electron beams, polymerisation progresses in vacuum (of the order of higher than $1 \times 10^{-4}$ Torr), and the width of a line of a pattern increases. After lapse of a certain length of time, this tendency subsides, and when the photoresist is placed in a vacuum of lesser degree, or in the atmosphere, the polymerisation ceases. According to a description on page 5 of the specification, the curing is carried out after pattern writing has been completed on the sample. After completion of curing, the sample is taken out of the curing chamber, and while maintaining the chamber in vacuum, the sample is transferred to a next stage of the process. On page 16 of the specification, it is described that the device of the invention allows the maintenance of the high degree of vacuum required for the curing.

According to one aspect of the present invention there is provided a method of processing negative photoresist, comprising exposing the negative photoresist to charged particle beams or soft X-ray beams in a vacuum, characterised in that, after such exposure, the negative photoresist is held in an atmosphere of non-oxidising for a length of time sufficient to substantially avoid occurrence of the curing effect, gas before being exposed to the outside atmosphere.

According to another aspect of the present invention there is provided apparatus for processing negative photoresist, comprising an exposure chamber, means for evacuating the exposure chamber, means for supporting the photoresist in the exposure chamber, and means for irradiating the supported photoresist with charged particle beams or soft x-ray beams, characterised in thahuthe apparatus further comprises a gas chamber communicating with the exposure chamber, means for introducing a non-oxidising gas into the gas chamber and means for transferring the photoresist into the gas chamber without exposure to the outside atmosphere.

A method embodying the present invention prescribes the keeping of a film of negative photoresist emulsion in an atmosphere of gas not containing oxygen, or containing substantially no oxygen, after exposure of the photoresist to electron beams or the like. Apparatus is provided for carrying out such a method.

The present invention offers a solution to the problem experienced in the conventional art by offering a method of keeping a substrate or wafer having negative photoresist emulsion thereon, that has been exposed to electron beams, for a predetermined length of time in an atmosphere of non-oxidising gas.

The present invention offers an improved electron beam exposure apparatus which eliminates the curing effect as described above and in which a mechanism is provided for introducing, and for keeping for a predetermined length of time, wafers which have been exposed to electron beams in a chamber filled with non-oxidising gas.

In one method embodying the present invention, a film of negative photoresist emulsion on a substrate to be treated is exposed, for pattern writing, in vacuum, to charged particle beams or soft X-ray beams, then the substrate coated with the photoresist film is transferred to, and kept in, a chamber having an atmosphere of non-oxidising gas, and is finally taken out of the chamber into the outside atmosphere.

In a method embodying the present invention, the non-oxidising gas may contain oxygen in an amount not more than 1% in volume terms.

A further method embodying the present invention comprises the following steps: irradiating charged particle beams or soft X-ray beams onto a substrate coated with a film of negative photoresist emulsion, to be treated for pattern writing exposure, in vacuum; transferring the substrate in vacuum to a gas chamber connected to the chamber where exposure is carried out; shutting off the exposure chamber from the gas chamber; introducing non-oxidising gas into the gas chamber and maintaining the substrate in an atmosphere of non-oxidising gas; and taking out the substrate from the atmosphere of non-oxidising gas to the outside atmosphere.

Another method embodying the present invention comprises the steps of: irradiating charged particle beams or soft X-ray beams onto a substrate coated with a film of negative photoresist emulsion to be greated for pattern writing exposure; transferring the substrate in vacuum to a sub-chamber connected to the exposure chamber; shutting off the connection between the exposure chamber and the sub-chamber; introducing non-oxidising gas into the sub-chamber and maintaining the substrate in an atmosphere of non-oxidising gas; transferring the substrate in the atmosphere of non-oxidising gas to a gas chamber connected to the sub-chamber; and taking out the substrate from the gas chamber to the outside atmosphere.

In one apparatus embodying the present invention, a gas chamber filled with non-oxidising gas is connected to an exposure chamber wherein charged particle beams are irradiated onto a film of negative photoresist on a substrate for pattern writing exposure, and the substrate, after exposure to processing is over in the exposure chamber, is kept in the atmosphere of non-oxidising gas in the gas chamber and then taken out to the outside atmosphere.

In another apparatus embodying the present invention, a sub-chamber is interposed between the exposure chamber and the gas chamber. Reference is made, by way of example, to the accompanying drawings, in which:—

Figure 1 is a graph illustrating relationships between the width or thickness of written patterns and the length of curing time after electron beam exposure,

Figures 2 to 4 are respective graphs, based upon experimental results, for assistance in explanation of the present invention,

Figures 5, 6 and 7A are schematic views of respective apparatuses embodying the present invention,

Figure 7B is a plan view of the apparatus shown in Figure 7A, and

Figures 8 and 9 are plan views of respective further apparatuses embodying the present invention.

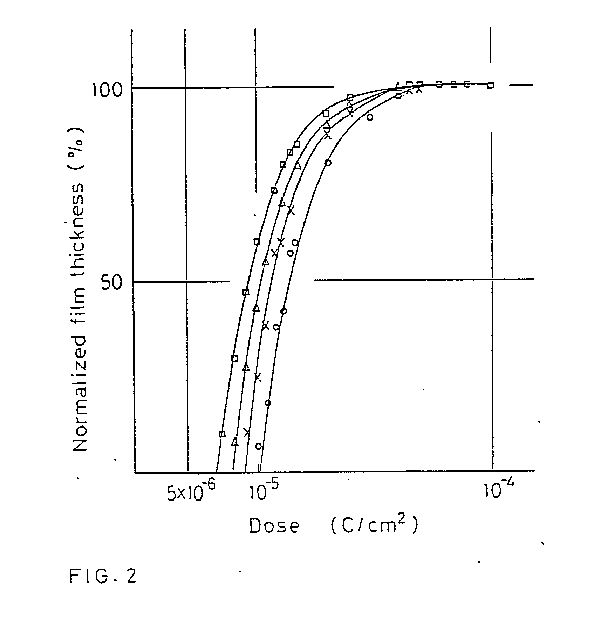

The inventors of the present invention carried out various experiments the results of which are shown in Figures 2 to 4.

In the graph of Figure 2 irradiated electron beam dose in Coulomb per $cm^2$ is indicated along the horizontal axis and normalised film thickness, or ratio of thickness of the photoresist film after development to thickness of the photoresist film before development (in %) is indicated along the vertical axis.

The curves in Figure 2 illustrate that film thickness increases proportionately as dose (in $C/cm^2$) increases. Wafers were coated with negative photoresist emulsion, poly - diaryl - ortho - phthalate (PDOP) for example; the photoresist film was prebaked at 60°C for 20 minutes, and postbaked at 90°C for 20 minutes. Wafers were taken out of vacuum as follows: soon after exposure without any curing time, and after curing times of 3 minutes, 10 minutes and 30 minutes, respectively. In the graph of Figure 2 results relating to wafers with 0 minute curing time are marked with circles, results relating to 3 minute curing time are marked with X marks, results relating to 10 minute curing time are marked with triangular marks, and results relating to 30 minutes curing time are marked with square marks.

The graph shows that normalised film thickness varies as to the amount of dose changes, and that it increases as the time for which the photoresist is left in vacuum after exposure to electron beams increases. It is understood that this phenomenon is due to curing or subsequent polymerisation which takes a certain length of time before it levels off. The mode of change of the illustrated normalised film thickness varies as the exposure system and negative photoresist emulsion are changed. However, with negative photoresist emulsion, the same trend is noted for all practical purposes. The width of a given pattern is proportionate to the normalised film thickness, and thinning in the width of a pattern makes it difficult to form fine patterns accurately.

The inventors of the present invention assumed that radicals remaining in the photoresist after exposure to electron beams vanish in the presence of an active gas such as oxygen, and conducted some experiments. Typical examples found in the experiments are as follows:

| condition | thickness (in μm) of photoresist film | pattern width (in μm) |
|---|---|---|
| in normal atmosphere | 1.04 | 1.73 |
| in vacuum, 30 min. | 1.17 | 2.06 |
| in nitrogen, 30 min. | 1.16 | 2.02 |

The results, obtained with poly - glycidyl - methacrylate (PGMA) photoresist emulsion show that in an atmosphere of inactive gas such as nitrogen, similar subsequent polymerisation to that occurring in vacuum is provided. Film thickness of the pattern after development is substantially equal to that before development, with a pattern width of 2 μm not thinning noticeably. This makes it clear that a film pattern can be fabricated with a high degree of precision.

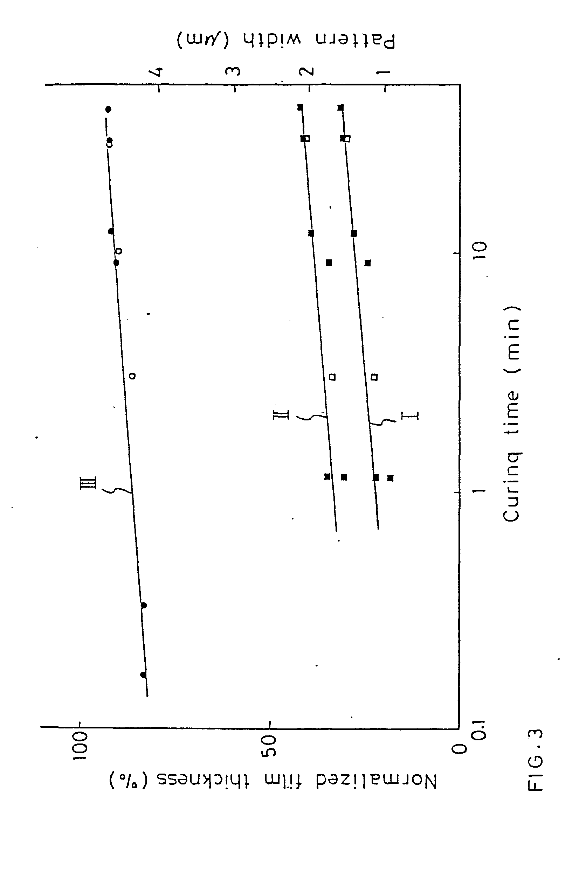

Detailed experimental results are shown in the graph of Figure 3 in which curing time is represented along the horizontal axis (in minutes), normalised film thickness is represented along the left vertical axis, and pattern width is represented along the right vertical axis. In the graph of Figure 3, curve I relates to a pattern line 1.5 µm wide, curve II a pattern line 2 µm wide, and curve III relates to normalised film thickness.

Negative photoresist (poly - diaryl - ortho - phthalate) initially 1.18 to 1.25 µm thick was prebaked at 60°C for 20 minutes. The emulsion was irradiated with an electron beam dosage of $3.5 \times 10^{-5}$ $C/cm^2$ at an energy of 20 KeV. Dark circles and dark squares indicate results obtained in vacuum, and plain circles and plain squares indicate results obtained in nitrogen atmosphere.

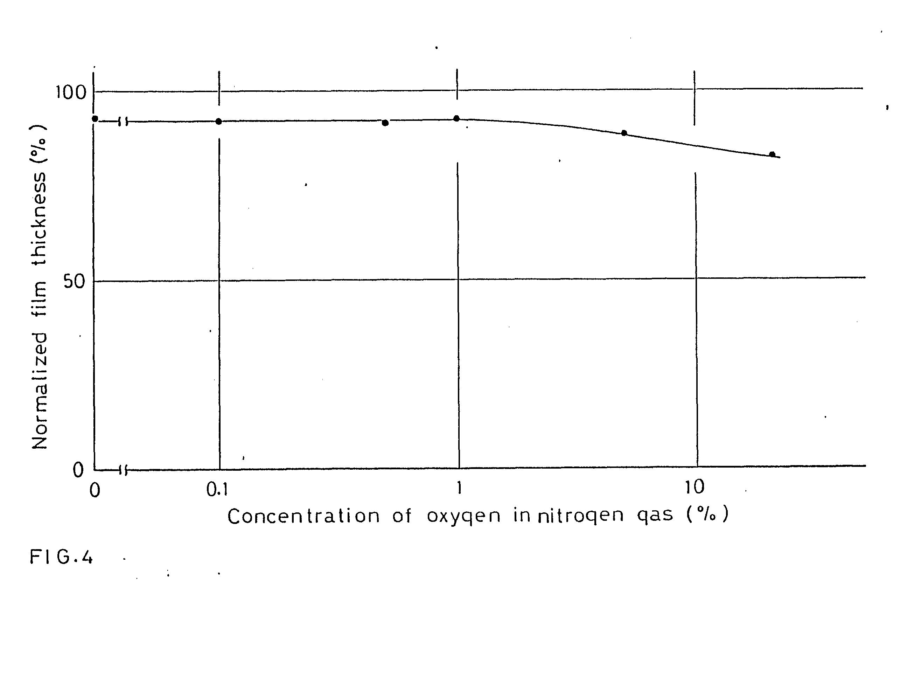

In a further experiment, it was found that, where the volume ratio of oxygen in the gas in which the exposed negative photoresist is kept is less than 1%, there is no substantial change in the value of normalised film thickness as compared with the case in which the negative photoresist is kept in vacuum. Where the oxygen concentration of the gas exceeds 5%, the normalised film thickness is changed. Details of experimental results are shown in the graph of Figure 4 in which concentration (in %) oxygen in nitrogen gas is shown on the horizontal axis, and normalised film thickness (in %) is shown on the vertical axis. Poly - diaryl - ortho - phthalate negative photoresist, initially 1.2 to 1.25 µm was prebaked at 60°C for 20 minutes. Electron beam dosage was in the order of $3.5 \times 10^{-5}$ $C/cm^2$, and the curing time was 30 minutes.

From the above, it will be understood that the maximum volume of oxygen that can be contained in gas in which the negative photoresist emulsion is kept is 1%.

According to a method embodying the present invention, a substrate to be treated which is coated with negative photoresist emulsion is exposed, and, without taking the substrate into the outside air, it is kept in nitrogen gas for a period in the range 30 minutes to 1 hour.

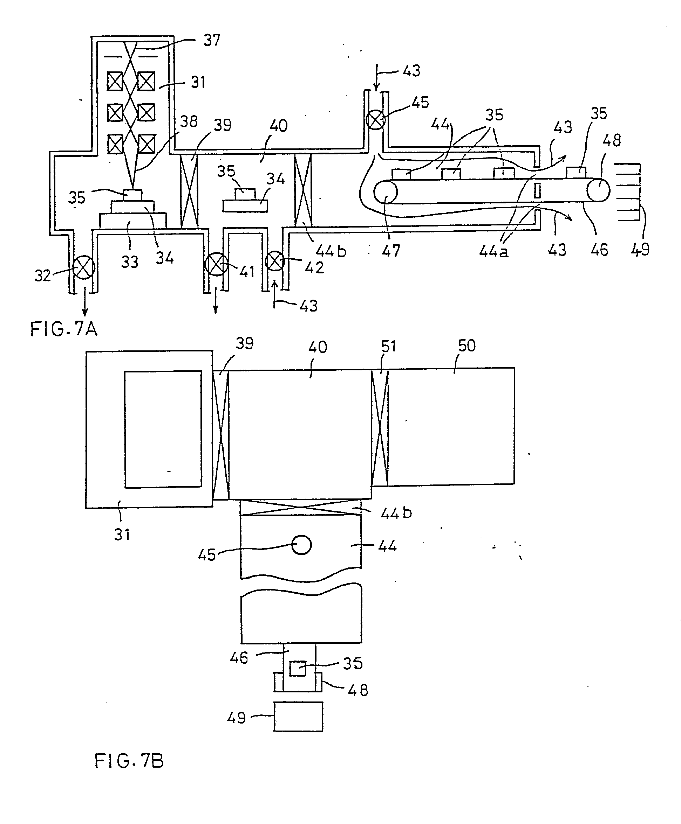

Apparatus embodying the present invention, for carrying out a method in accordance with the invention, is schematically illustrated in Figure 5.

A semiconductor substrate 2 placed in a stage chamber 1 of an apparatus for electron beam exposure is exposed to electron beans in vacuum. Exhaustion of air to keep the stage chamber 1 in vacuum is stopped, and nitrogen gas is introduced into the chamber 1. The substrate 2 is then transferred as indicated by an arrow in Figure 5 to a chamber 3 which has been filled with nitrogen gas. The substrate 2 is kept in chamber 3 for a period of from 30 minutes to 1 hour, and is subsequently taken out into the outside air. The length of time during which the substrate 2 is kept in the nitrogen filled chamber 3 depends on the kind of negative photoresist emulsion and the type of exposure used. The apparatus of Figure 5 is as effective for forming high precision patterns on a semiconductor substrate as apparatus in which the substrate is kept in vacuum after exposure. It was confirmed that in the illustrated apparatus of Figure 5, rate of operation is improved considerably.

A method in accordance with the present invention may alternatively be carried out in electron beam exposure apparatus as illustrated in Figure 6. The apparatus of Figure 6 comprises an exposure chamber 11, a loading chamber 12 and a store chamber 13 where substrates are temporarily held. The loading chamber 12 is provided with a pre-exhausting chamber 14, and the store chamber 13 with an unloading chamber 15. The pre-exhausting chamber 14 and the loading chamber 12 are connected by a gate valve 16 by which these chambers are either open to, or shut off from, one another. The loading chamber 12 and the exposure chamber 11 are similarly connected by a gate valve 17. Likewise, the exposure chamber 11 and the store chamber 13 may be open to, or shut off from, each other by a gate valve 18. Similarly, the store chamber 13 and the unloading chamber 15 are connected by a gate valve 19.

In operation, the gate valve 16 to the pre-exhausting chamber 14 and the gate valve 19 to the unloading chamber 15 are closed, and in the illustrated electron beam apparatus, air is exhausted from the loading chamber 12, exposure chamber 11 and the store chamber 13 to keep these chambers in a high degree of vacuum. The unloading chamber 15 is in advance filled with non-oxidising gas. A cassette 21 loaded with some ten wafers 20 is set up in the pre-exhausting chamber 14, then air in the chamber 14 is exhausted preliminarily. After this preliminary exhaustion of air is complete, the gate valve 16 is opened, and the cassette 21 is transferred from the pre-exhaustion chamber 14 to the loading chamber 12 which is kept in a high degree of vacuum, and the gate valve 16 is closed.

The first wafer 20 in the cassette 21 which has been transferred to the loading chamber 12 is moved from the loading chamber 12 to an XY stage 22 in the exposure chamber 11 by a conventional transfer mechanism such as a mechanical pick-up, not shown, and is set up therein. After the degree of vacuum in the exposure chamber 11 has reached a predetermined value, the first wafer 20 is irradiated by electron beams.

After the exposure is completed, the wafer 20 is transported from its position on the XY stage 22 in the exposure chamber 11 onto a sample stage 23 in the store chamber 13 by a known transfer mechanism, not shown. The second wafer in the cassette 21 is transported from the loading chamber 12 onto the XY stage 22 in the exposure chamber 11 by the transfer mechanism mentioned previously, and is set up. The gate valve 18 is closed to disconnect and shut off the exposure chamber 11 and the store chamber 13 from each other. After the degree of vacuum in the exposure chamber 11 has attained a predetermined value, the second wafer is exposed to electron beams. While the second and next wafers are being exposed, the first wafer, which is shut off from the exposure chamber 11, is recovered as will be described.

The gate valve 19 between the store chamber 13 and the unloading chamber 15 is open to maintain the store chamber 13 in an atmosphere of non-oxidising gas. Then, the first wafer 20 on a sample stage 23 in the store chamber 13 is carried into an empty cassette 24 in the unloading chamber 15 by a conventional transfer mechanism not shown. After the first wafer has been placed in the cassette 24, the gate valve 19 is closed to shut off the unloading chamber 15 and the store chamber 13 from sach other and the store chamber 13 is exhausted to provide a high degree of vacuum therein.

After exposure of the second wafer to electron beams in the exposure chamber 11, it will be ascertained that the store chamber 13 is being maintained in a predetermined high degree of vacuum. After this is done, the gate valve 18 is open, and the second wafer on the XY stage 22 in the exposure chamber 11 is carried, by the above described transfer mechanism, onto the sample stage 23 in the store chamber 13.

The third wafer in the cassette chamber 21 is transported, by the same transfer mechanism, from the loading chamber 12 onto the XY stage 22 in the exposure chamber 11. Thereafter, steps as described above are successively repeated under the control of a program that has been prepared in advance.

Wafers that have been exposed to electron beams are carried to the empty cassette 24 in the unloading chamber 15 kept in a non-oxidising atmosphere and retained in the cassette 24. After keeping these wafers in the unloading chamber 15 for a predetermined length of time, the wafers are taken out into the outside atmosphere. It is preferable to design the store chamber 13 to be of compact and small size so that the rate of exhausting thereof may be enhanced. Alternatively, two such store chambers may be provided for use alternately, to improve the rate of operation of the exposure apparatus.

A further apparatus embodying the present invention is illustrated in Figures 7A and 7B.

Figure 7A is a schematic view for assistance in explanation of the operation of the apparatus, and Figure 7B is a plan view illustrating the layout of various parts of the apparatus.

Air in a main chamber 31 of an apparatus for electron beam exposure is exhausted in a known manner by a vacuum pump (not shown) through an exhaust valve 32 to maintain the main chamber 31 in vacuum. A stage 33 is provided in the main chamber 31, and a sample such as wafer 35 is placed on a sample holder 34 on the stage 33. Electron beams 38, to be used for electron beam exposure, from a cathode 37 of an electron gun of conventional structure are irradiated onto the sample 35 to write a predetermined exposure pattern. In this case, negative photo resist emulsion is coated on the sample 35 for pattern exposure. The sample 35, after exposure, is taken out as loaded on the sample holder 34 into a sub-chamber 40 through a first gate valve 39. When removing the sample 35 on the sample holder 34 into the sub-chamber 40, an exhaust valve 41 is opened for operation of a vacuum pump (not shown) to keep the sub-chamber 40 in vacuum in advance, and with the main chamber 31 being kept in operable vacuum, the first gate valve 39 is then closed. An inlet valve 42 is opened to introduce into the sub-chamber 40 non-oxidising gas which does not contain oxygen, or a gas that contains oxygen atoms, such as nitrogen, argon, helium or a mixture of these. (Of course, as indicated above, an amount of oxygen of at most 1% by volume may be included). When the pressure of non-oxidising gas 43 becomes the same as, or slightly higher than, that of non-oxidising gas in a gas chamber 44 to be described later, a third gate valve 44b is opened. The sample 35 is removed from the sample holder 34 and taken into the gas chamber 44.

The above described gas 43 enters the gas chamber 44 through an inlet valve 45 and is exhausted through an exhaust or a second gate valve 44a, so that there is always a continuous flow of non-oxidising gas 43. Internally of the gas chamber 44 there is provided a first roller 47 for a belt conveyor 46, and a second roller 48 is provided outside the gas chamber 44. The belt conveyor 46 surrounds these two rollers, and the samples 35 taken out of the sub-chamber 40 are successively placed on, and carried by, the belt conveyor 46. Samples 35 are gradually moved, staying within the gas chamber 44, for a predetermined period of time during which the curing effect described above takes place. The samples 35 taken out of the gas chamber 44 through an exhaust port 44a are exposed to the outside air for the first time and are placed in a cassette 49.

A next sample 35 to be placed in main chamber 31 is introduced through a sample insert chamber 50 shown in Figure 7B. A third gate 51 opened, and the sample 35 is carried into the sub-chamber 40.

In these operations for introducing a next sample, the insides of the sample insert chamber 50 and the sub-chamber 40 are generally kept in the same state as the outside atmosphere, and curing is effected with the third gate 51 closed. It will be clearly understood that for delivery of the next sample the first gate 39 is closed, and when the next sample 35 is secured on the sample holder 34 in the sub-chamber 40, the exhaust valve 41 is opened to keep the sub-chamber 40 in vacuum, then the first gate 39 is opened and the sample holder 34 with the sample 35 thereon is placed on the XY stage 33. Thus, the sample is positioned at a predetermined position ready for exposure.

In the above described embodiment, the sample insert chamber 50 and the sub-chamber 40 are kept in the same condition as the outside atmosphere at the time when a next sample is brought in. Where non-oxidising gas 43 is introduced into chamber 50 and sub-chamber 40 during bringing in of the next sample, the second gate 44a may be left open. It will be understood that, because of this, the second gate valve 44a can be constructed easily without being subjected to severe conditions.

As described above, oxygen in a proportion less than or not greater than 1% in volume may harmlessly be mixed into the non-oxidising gas during the curing. In the event that air enters through the second gate valve 44a, which is open to allow movement of the belt conveyor, the volume of oxygen can be held down to less than 1% by continuously supplying the non-oxidising gas.

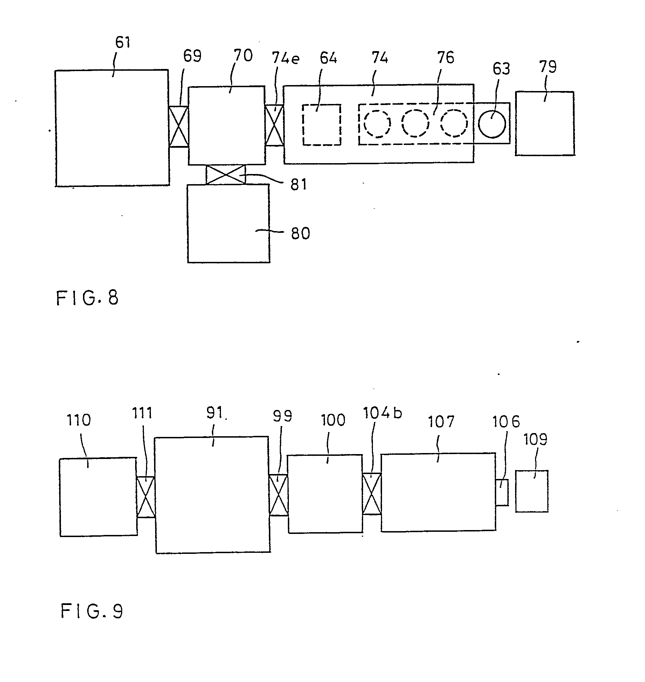

Figure 8 illustrates another apparatus embodying the present invention. In the apparatus of Figure 8, 61 is a main chamber corresponding to main chamber 31 in Figure 7A, 69 is a valve corresponding to valve 39, and items 64, 70, 74, 74e, 76, 79, 80 and 81 correspond to items 34, 40, 44, 44b, 46, 49, 50 and 51 in 7A. In the apparatus of Figure 8, placing of a sample 63 on a sample holder 64 is not carried out in a sub-chamber 70. Instead, setting up of the sample 63 from a sample introduction chamber 80 and removal of sample 63 from a belt conveyor 76 into a cassette 79 are effected by means of the sample holder 64 provided in a gas chamber 74.

By such an arrangement, there is no need to carry out setting up and removal of samples in a sub-chamber 70 which is built to a relatively small size so that it can more readily be kept to a sufficient degree of vacuum for exposure operations. In the gas chamber 64, handling of the samples can very easily be performed.

Figure 9 illustrates a further embodiment of the present invention. In Figure 9, items 110, 111, 91, 99, 100, 104b, 107, 106 and 109 correspond in general function to items 50, 51, 31, 39, 40, 44b, 44, 46 and 49 in Figure 7A. In Figure 9, a sample introduction chamber 110 is placed near one side of a main chamber 91. Because of this arrangement an entire process can be carried out using a belt conveyor 106 along a production line as follows: Introduction of samples (in a sub-chamber 110)—exposure (in a main chamber 91)—curing (in sub-chamber 100)—removal of samples (in chamber 107)—placing of the samples in a cassette 109. This arrangement avoids complexities of structure such as might arise where the sample introduction chamber 110 annexed to or combined with a sub-chamber 100 or gas chamber 107.

As described above, a method embodying the present invention makes it possible to form patterns with a high degree of precision, employing non-oxidising gas in place of a vacuum. Since samples to be exposed are moved in the non-oxidising gas handling thereof is facilitated. This serves to reduce the cost of manufacture of semiconductor devices such as highly integrated circuits.

Apparatus embodying the present invention structured and operated as described above can provide continuous and effective exposure with little time wastage. As samples are set up and removed not in vacuum, handling of samples is simplified, with the samples showing no signs of the curing effect.

The method and apparatus of the present invention are not limited to cases in which electron beams are used. The method and apparatus are just as effective when ion beams, soft X-ray beams or the like are employed.

An exposure method embodying the present invention has a feature that, after a film of negative photoresist emulsion on a substrate has been exposed for pattern writing in vacuum to charged particle beams or soft X-ray beams, the substrate coated with the photoresist film is transferred to, and kept in, a chamber filled with non-oxidising gas, then the substrate is taken out into the outside atmosphere. Thereby, curing effect on the photoresist film is avoided, enabling formation of fine patterns with precision. In an apparatus embodying the present invention, such a method can be carried out, the apparatus having a structure such that a gas chamber filled with non-oxidising gas is connected to a chamber where exposure is carried out, and the substrate, after such exposure, is kept in an atmosphere of non-oxidising gas in the gas chamber before being taken out into the outside atmosphere.

## Claims

1. A method of processing negative photoresist, comprising exposing the negative photoresist to charged particle beams or soft X-ray beams in a vacuum, characterised in that, after such exposure, the negative photoresist is held in an atmosphere of non-oxidising gas for a length of time sufficient to substantially avoid occurrence of the curing effect, before being exposed to the outside atmosphere.

2. A method as claimed in claim 1, wherein the non-oxidising gas comprises nitrogen, argon or helium, or a mixture thereof.

3. A method as claimed in claim 1 or 2, wherein the non-oxidising gas contains an amount of oxygen not greater than 1% with respect to volume.

4. A method as claimed in any preceding claim, wherein the negative photoresist is held in the non-oxidising gas for a period of time in the range 30 minutes to 1 hour.

5. A method as claimed in any preceding claim, comprising the steps of:

irradiating a substrate coated with negative photoresist emulsion with charged particle beams or soft X-ray beams for pattern writing in vacuum, transferring the substrate, in vacuum, to a gas chamber connected to the exposure chamber in which the irradiation is carried out, shutting off the exposure chamber and the gas chamber from one another, introducing non-oxidising gas into the gas chamber to hold the substrate in an atmosphere of non-oxidising gas, and taking the substrate out of the atmosphere of non-oxidising gas into the outside atmosphere.

6. A method as claimed in any one of claims 1 to 4, comprising the steps of: irradiating a substrate coated with a film of negative photoresist emulsion with charged particle beams or soft X-ray beams for pattern writing, transferring the substrate in vacuum to a sub-chamber connected to the exposure chamber where such irradiation is carried out, shutting off the exposure chamber and the sub-chamber from one another, introducing non-oxidising gas into the sub-chamber to hold the substrate in an atmosphere of non-oxidising gas, transferring the substrate, in the atmosphere of non-oxidising gas, to a gas chamber connected to the sub-chamber, and taking the substrate out of the gas chamber into the outside atmosphere.

7. A method as claimed in any preceding claim, wherein the negative photoresist is exposed to electron beams.

8. A method as claimed in any one of claims 1 to 6, wherein the negative photoresist is exposed to ion beams.

9. A method as claimed in any preceding claim, wherein the negative photoresist is poly - glycidyl - meth - acrylate (PGMA) or poly - diaryl - ortho - phthalate (PDOP).

10. Apparatus for processing negative photoresist, comprising an exposure chamber, means for evacuating the exposure chamber, means for supporting the photoresist in the exposure chamber, and means for irradiating the supported photoresist with charged particle beams or soft x-ray beams, characterised in that the apparatus further comprises a gas chamber communicating with the exposure chamber, means for introducing a non-oxidising gas into the gas chamber and means for transferring the photoresist into the gas chamber without exposure to the outside atmosphere.

11. Apparatus as claimed in claim 10, wherein a sub-chamber is interposed between the gas chamber and the exposure chamber.

**Patentansprüche**

1. Verfahren zur Behandlung eines negativen Fotoresists, bei welchem das negative Fotoresist geladenen Teilchenstrahlen oder weichen Röntgenstrahlen in einem Vakuum exponiert wird, dadurch gekennzeichnet, daß nach einer solchen Exponierung das negative Fotoresist in einer Atmosphäre aus nicht-oxidierendem Gas während einer Zeitlänge gehalten wird, welche ausreicht, um im wesentlichen das Eintreten des Aushärtungseffektes zu vermeiden, bevor es der äußeren Atmosphäre ausgesetzt wird.

2. Verfahren nach Anspruch 1, bei welchem das nicht-oxidierende Gas Stickstoff, Argon, Helium oder eine Mischung davon enthält.

3. Verfahren nach Anspruch 1 oder 2, bei welchem das nicht-oxidierende Gas eine Menge von Sauerstoff enthält, die nicht größer als 1% bezüglich des Volumens ist.

4. Verfahren nach einem der vorhergehenden Ansprüche, bei welchem das negative Fotoresist während einer Zeitperiode im Bereich von 30 Minuten bis 1 Stunde in dem nicht-oxidierenden Gas gehalten wird.

5. Verfahren nach einem der vorhergehenden Ansprüche, mit den folgenden Schritten:

Bestrahlung eines Substrats, welches mit einer negativen Fotoresistemulsion überzogen ist, mit geladenen Teilchenstrahlen oder mit weichen Röntgenstrahlen, um ein Muster zu schreiben, im Vakuum, Transfer des Substrats, im Vakuum, zu einer Gaskammer, die mit der Exponierungskammer verbunden ist, in welcher die Bestrahlung durchgeführt wird, Abtrennen der Exponierungskammer und der Gaskammer voneinander, Einführung eines nicht-oxidierenden Gases in die Gaskammer, um das Substrat in einer Atmosphäre von nicht-oxidierendem Gas zu halten, und Entnahme des Substrats aus der Atmosphäre des nicht-oxidierenden Gases in die äußere Atmosphäre.

6. Verfahren nach einem der Ansprüche 1 bis 4, mit den folgenden Schritten:

Bestrahlen eines Substrats, das mit einem Film aus negativer Fotoresistemulsion überzogen ist, mit geladenen Teilchenstrahlen oder weichen Röntgenstrahlen, um Muster zu schreiben, Transfer des Substrats im Vakuum zu einer Sub-Kammer, die mit der Exponierungskammer verbunden ist, wo solch eine Bestrahlung durchgeführt wird, Abtrennen der Exponierungskammer und der Sub-Kammer voneinander, Einführung eines nicht-oxidierenden Gases in die Sub-Kammer, um das Substrat in einer Atmosphäre von nicht-oxidierendem Gas zu halten, Transfer des Substrats, in der Atmosphäre des nicht-oxidierenden Gases, zu einer Gaskammer, die mit der Sub-Kammer verbunden ist, und Entnahme des Substrats aus der Gaskammer in die äußere Atmosphäre.

7. Verfahren nach einem der vorhergehenden Ansprüche, bei welchem das negative Fotoresist Elektronenstrahlen exponiert wird.

8. Verfahren nach einem der Ansprüche 1 bis 6, bei welchem das negative Fotoresist Ionenstrahlen exponiert wird.

9. Verfahren nach einem der vorhergehenden Ansprüche, bei welchem das negative Fororesist ein Poly - glycidyl - methacrylat (PGMA) oder ein Poly - diaryl - ortho - phthalat (PDOP) ist.

10. Vorrichtung zur Verarbeitung eines negativen Fotoresists, mit einer Exponierungskammer, Einrichtungen zur Evakuierung der Exponierungskammer, Einrichtungen zur Unterstützung des Fotoresists in der Exponierungskammer und Einrichtungen zur Bestrahlung des unterstützten Fotoresists mit geladenen Teilchenstrahlen oder weichen Röntgenstrahlen, dadurch gekennzeichnet, daß die Vorrichtung ferner eine Gaskammer umfaßt, die mit der Exponierungskammer kommuniziert, und Einrichtungen zur Einführung eines nicht-oxidierenden Gases in die Gaskammer, und Einrichtungen zum Transfer des Fotoresists in die Gaskammer ohne Exponierung gegenüber der äußeren Atmosphäre.

11. Vorrichtung nach Anspruch 10, bei welcher eine Sub-Kammer zwischen der Gaskammer und der Exponierungskammer angeordnet ist.

## Revendications

1. Procédé de traitement d'agent photosensible négatif, qui consiste à exposer l'agent photosensible négatif à des faisceaux de particules chargèes ou des faisceaux de rayons X mous dans le vide, caractérisé en ce que, après cette exposition, on maintient l'agent photosensible négatif dans une atmosphère de gaz non oxydant pendant une durée suffisante pour éviter sensiblement l'apparition de l'effet de durcissement, avant de l'exposer à l'atmosphère extérieure.

2. Procédé selon la revendication 1, où le gaz non oxydant comprend l'azote, l'argon ou l'hélium, ou bien un mélange de ceux-ci.

3. Procédé selon la revendication 1 ou 2, où le gaz non oxydant contient une quantité d'oxygène non supérieure à 1% en volume.

4. Procédé selon l'une quelconque des revendications précédentes, où on maintient l'agent photosensible négatif dans le gaz non oxydant pendant une durée comprise entre 30 min et 1 h.

5. Procédé selon l'une quelconque des revendications précédentes, comprenant les opérations suivantes:

irradier un substrat revêtu du l'émulsion d'agent photosensible négatif à l'aide de faisceaux de particules chargées ou de faisceaux de rayons X mous en vue de l'écriture de configurations dans le vide, transfèrer le substrat, dans le vide, jusqu'à une chambre à gaz reliée à la chambre d'exposition dans laquelle l'irradiation a été effectuée, isoler la chambre d'exposition et la chambre à gaz l'une de l'autre, introduire le gaz non oxydant dans la chambre à gaz pour maintenir le substrat dans une atmosphère de gaz non oxydant, et extraire le substrat de l'atmosphère de gaz non oxydant pour le placer dans l'atmosphère extérieure.

6. Procédé selon l'une quelconque des revendications 1 à 4 comprenant les opérations suivantes:

irradier un substrat revêtu d'une pellicule d'émulsion d'agent photosensible négatif à l'aide de faisceaux de particules chargées ou de faisceaux de rayons X mous en vue de l'écriture de configurations, transfèrer le substrat, dans le vide, jusqu'à une sous-chambre reliée à la chambre d'exposition où cette irradiation a été effectuée, isoler la chambre d'exposition et la sous-chambre l'une de l'autre, introduire un gaz non oxydant dans la sous-chambre pour maintenir le substrat dans une atmosphère de gaz non oxydant, transfèrer le substrat, qui se trouve dans l'atmosphère de gaz non oxydant, jusqu'à une chambre à gaz reliée à la sous-chambre, et extraire le substrat de la chambre à gaz pour le placer dans l'atmosphère extérieure.

7. Procédé selon l'une quelconque des revendications précédentes, où on expose l'agent photosensible négatif à des faisceaux d'électrons.

8. Procédé selon l'une quelconque des revendications 1 à 6, où l'on expose l'agent photosensible négatif à des faisceaux d'ions.

9. Procédé selon l'une quelconque des revendications précédentes, où l'agent photosensible négatif est le polyméthacrylate de glycidyle (PMAG) ou le polyorthophtalate de diaryle (POPD).

10. Appareil permettant de traiter un agent photosensible négatif, comprenant une chambre d'exposition, un moyen servant à faire le vide dans la chambre d'exposition, un moyen servant à supporter l'agent photosensible dans la chambre d'exposition, et un moyen servant à irradier l'agent photosensible ainsi supporté au moyen de faisceaux de particules chargées ou de faisceaux de rayons X mous, caractérisé en ce que l'appareil comprend en outre une chambre à gaz qui communique avec la chambre d'exposition, un moyen servant à introduire un gaz non oxydant dans la chambre à gaz, et un moyen servant à transfèrer l'agent photosensible dans la chambre à gaz sans exposition à l'atmosphère extérieure.

11. Appareil selon la revendication 10, où une sous-chambre s'intercale entre la chambre à gaz et la chambre d'exposition.

FIG.1

FIG. 5

FIG. 6

FIG. 2

FIG.3

FIG.4

FIG.7A

FIG.7B

5

FIG. 8

FIG. 9